# EUROPÄISCHE PATENTANMELDUNG

(11) **EP 0 752 483 A1**
(43) Veröffentlichungstag der Anmeldung: **08.01.1997**
(21) Anmeldenummer: 96110266.2
(22) Anmeldetag: 26.06.1996
(51) Int. Cl.: C23C 16/40, C23C 16/30, B05D 7/24

(54) **Verfahren zur Beschichtung von Gegenständen aus Metall oder Kunststoff**

(30) Priorität: 28.06.1995 DE 19523444; 28.06.1995 DE 19523442
(71) Anmelder: ANTEC Angewandte Neue Technologien GmbH, D-65779 Kelkheim (DE)
(72) Erfinder: Hartmann, Rolf, Dipl.-Ing., 65779 Kelkheim (DE); Ronge, Werner, Dipl-Ing., 64546 Mörfelden-Walldorf (DE); Tschentscher, Armin, Dipl.-Ing., 65439 Flörsheim (DE)
(74) Vertreter: Reichel, Wolfgang, Dipl.-Ing.

(57) **Zusammenfassung**

Verfahren zur Beschichtung von Gegenständen aus Metall, Metall-Legierungen, Kunststoffen oder entsprechenden Oberflächen mit einer Schutzschicht nach vorheriger Reinigung mittels eines plasmaunterstützten CVD-Verfahrens (PACVD-Verfahrens) durch eine elektrische Plasmaanregung bei vermindertem Gasdruck unter Einleitung einer Gasmischung mit reaktionsfähigen, schichtbildenden Gasen und Steuerung des Arbeitsdrucks, wobei zur Bildung einer quarzartigen Schicht als die reaktionsfähigen Gase neben Sauerstoff den Dampf einer das Element Silizium in organischer Verbindung enthaltenden, leicht verdampfbaren siliziumorganischen Verbindung oder ein siliziumhaltiges Gas in einer solchen Mischung eingeleitet werden, daß der Anteil des reaktiven Sauerstoffs nicht zur quantitativen Umsetzung zu Siliziumdioxid ausreicht, und daß die Substratspannung der elektrischen Gasentladung so gesteuert wird, daß sich eine transparente Schicht mit einer quarzähnlichen Struktur aus Silizium, Sauerstoff und organischen Anteilen bildet, die die Oberfläche zuverlässig gegen chemischen Angriff schützt und gleichzeitig einen wirksamen Kratzschutz darstellt, ohne den metallisch blanken Eindruck einer polierten oder auch mattierten Oberfläche zu beeinträchtigen.

## Beschreibung

Die Erfindung betrifft ein Verfahren zur Beschichtung von Gegenständen aus Metall, Metall-Legierungen, Kunststoffen oder entsprechenden Oberflächen gemäß dem Oberbegriff des Patentanspruchs 1.

Es werden zur Erzielung von z.B. verschleißmindernden oder anderen Schichten bereits seit den 70iger Jahren plasmaunterstützte CVD-Verfahren vorgeschlagen. Dabei haben sich z.B. auf diese Weise aufgebrachte TiN-Schichten als abriebfeste harte Schichten auf Stählen bewährt. Es besteht jedoch immer noch ein Bedarf an kostengünstigen und möglichst mit Raumtemperatur der zu beschichtenden Substrate ablaufenden Beschichtungsverfahren, die auch auf beliebigen anderen Metallen gut haftende, farblose und kratzfeste, korrosionsschützende Schichten erzeugen. So ist es, wie im folgenden dargelegt, insbesondere auf unedleren Metallen und Metall-Legierungen sowie auch blanken Metalloberflächen schwierig, wirklich gut und dauerhaft haftende Schichten zu erzeugen, ohne die metallische Oberfläche stark zu verändern.

Auch Produkte aus polymeren Werkstoffen neigen wegen der verhältnismäßig weichen Oberfläche zum Zerkratzen. Dies gilt insbesondere für klare und farblos-durchsichtige Polymere, wie sie für Sichtfenster, Behälter und auch für Brillengläser Verwendung finden. Für die verschiedenen Anwendungen ist ein wirksamer Schutz der kratzempfindlichen Oberfläche erforderlich, um den betreffenden Gegenständen eine ausreichende Gebrauchstüchtigkeit zu verleihen.

Blanke, polierte Oberflächen nicht edler Metalle wie z.B. Messing benötigen bekanntermaßen einen geeigneten, farblosen und hermetisch dichten Korrosions- und Anlaufschutz, um ein Oxidieren oder Anlaufen zu vermeiden und den Glanz lange Zeit aufrecht zu erhalten. Aluminium und Aluminiumlegierungen schützen sich vor Oxidation durch ihr eigenes dichtes Oxid, das auch elektrochemisch noch verstärkt werden kann (durch das Eloxalverfahren). Ähnliches gilt für Chrom. Andere Metalle und Legierungen wie insbesondere Messing oder Silber bilden kein sich selbst schützendes farbloses Oxid, sondern laufen sehr schnell dunkel an.

Als Schutzschicht für blanke Metalloberflächen und insbesondere für Messing hat sich ein Überzug aus einem farblosen Lack bewährt (z.B. Zaponlack). Der Lack schützt gut gegen Korrosion, so lange keine mechanische Belastung auf ihn einwirkt. Wegen seiner geringen Festigkeit wird er leicht durchstoßen. Durch die Einlagerung sehr fester, kleinster Partikel aus z.B. oxidischen Verbindungen kann eine merkliche Verbesserung der mechanischen Widerstandsfähigkeit der Lack-Beschichtung erreicht werden. Ungeachtet dessen birgt die organische Komponente des Systems die Gefahr, daß durch die Belastung der Schicht durch die ultraviolette Strahlung des Tageslichts bei Außenanwendung es zu Schichtzerstörungen und/oder Ablösungen kommt.

Wird blank poliertes Metall ohne Lackschicht zusätzlich noch einer mechanischen Beanspruchung unterworfen, so werden durch den mechanischen Verschleiß und das Zerkratzen die Politur und der Glanz der Oberfläche schnell zerstört. Zwar wirkt das eigene Oxid verschiedener Metalle, wie oben dargelegt, nach entsprechender Verstärkung auch dem kratzenden Verschleiß entgegen, doch sind dann die Eigenschaften der Schichten nur in geringem Maß an die jeweiligen Erfordernisse anpaßbar.

Während einfache Geometrien relativ leicht durch Spritzen oder Tauchen mit diesem Lack überzogen werden können, bereiten Hinterschneidungen und Kanten erhebliche Probleme, da sie den gleichmäßigen Auftrag des Lacks behindern. Darüber hinaus ist bekannt, daß relativ hart auftrocknende Lacke zur Sprödigkeit neigen, was in Kombination mit dem polymeren Grundwerkstoff die Gefahr einer Rißbildung zur Folge hat. In jedem Fall muß die Haftung des Lacks auf der zu lackierende Oberfläche sichergestellt sein, was bei chemisch sehr unterschiedlichen polymeren Werkstoffen nur schwer zu realisieren ist.

Es sind eine Reihe von Verfahren der Erzeugung harter und kratzfester Schichten mit Hilfe von verschiedenen Vakuumverfahren bekannt. So werden z.B. mittels des plasmaunterstützten CVD-Verfahren (PACVD-Verfahrens) bei hoher Substrattemperatur um 1000 °C auf entsprechend wärmestabilen optischen Oberflächen SiO₂-Schichten aufgebracht.

Es ist ferner bekannt, Kunststoffe mit dünnen Quarzschichten als Permeationssperre nach dem plasamunterstützten CVD-Verfahren gemäß dem Oberbegriff des Patentanspruchs 1 zu beschichten. Hierbei werden in der Regel durch einen stöchiometrischen überschuß im zugeführten O₂- oder auch N₂O-Reaktionsgas möglichst perfekte oxidische Schichten erzeugt, wie beispielsweise in der US 5 364 666, EP 0622 399 A1, EP 0469 926 A1, US 5422 441). Es werden auch, wie in der EP 0469 926 A1 und der US 5224 441 sehr geringe Zusätze an Methan, Propylen und Acetylen zugesetzt, um die Schicht silikonartig zu modifizieren. In der WO 93 242 43 A1 wirkt das Plasma nur auf die oxidische Komponente wie z.B. das O₂ und nicht auf den siliziumorganischen Dampf, der damit nicht dem Plasma ausgesetzt und aufgespalten wird, so daß nicht verhindert werden kann, daß ein gewisser Anteil einer aus diesem Dampf resultierenden organischen Komponente in der Schicht neben den gewünschten SiOₓ-Reaktionsprodukten vorhanden ist. Die EP 0622 474 A1 arbeitet ebenfalls bevorzugt mit Sauerstoffüberschuß und zudem mit einem Überdruck von etwa 10 000 Pa im Reaktionsraum.

Zur Erzielung einer kratzfesten Beschichtung auf Kunststoffen lehrt die US 51 56 882 einen mehrlagigen Schichtaufbau aus SiO₂/TiO₂/SiO₂-Schichten. Auch die US 42 60 647 und die US 40 96 315 wenden mehrstufige Beschichtungsverfahren an, wobei bei der US 42 60 647 während der Aufbringung der etwa 1000 Angström dicken SiOₓ-Schicht das Verfahren mehrfach unterbrochen wird, um durch zwischengeschaltete Sauerstoffnachbehandlungen möglichst perfekte oxidische Schichten nachzuoxidieren und in der US 40 96 315 zunächst mit einem Hydroxylgruppen auf einer Linsenoberfläche erzeugenden Plasma beschichtet wird, bevor die SiOₓ-Schichten aufgebracht werden. Nach der DE 43 38 040 A1 werden kratzfeste und reflexmindernde Brillenglasbeschichtungen z.B. durch im Plasmaimpulsbetrieb aufgebrachte SiO₂-Schichten erzeugt. Zur Brechzahlanpassung einer Entspiegelungsschicht werden in der DE 43 42 463 A1 in der Beschichtungskomponente SiOₓN_{y} x und y variiert. Ähnliche Beschichtungen lehrt auch die DE 42 39 511 A1.

Ferner beschreiben etliche Schriften (z.B. US 53 30 577 und JP 4-341568 A) die Beschichtung von Siliziumwafern für die Halbleitertechnik mit SiOₓ-Schichten. Die EP 0 665 307 A2 erzeugt ebenfalls reine SiOₓ-Schichten unter Mikrowellenanregung, wobei das Verhältnis O₂/SiH₄ und die durch eine zusätzlich installierte, schwache Hochfrequenz-Hilfsentladung am Substrat erzeugte Substrat-Biasspannung so eingestellt werden, daß die innere Spannung der resultierenden Schicht optimiert wird. Dabei wurde u.a. ermittelt, daß die innere Spannung abnimmt, wenn das Verhältnis O₂/SiH₄ im Reaktionsgas erhöht wird, und Null wird, wenn die Leistung der Hochfrequenz-Hilfsentladung 10 W beträgt. Kunststoff-, Glas- oder Metallflaschen werden ferner in der EP 0 503 820 A1 mit anorganischen Siliziumoxidschichten mit hohem Vernetzungsgrad z.B. mittels TMDSA, Sauerstoff und Helium im plasmaunterstützten CVD-Verfahren erzeugt.

In der DE 40 39 352 A1 werden auf Kunststoff zunächst eine Vorschicht im Plasma-CVD-Verfahren aus einer SiCO- oder SiC-Atmosphäre aufgebracht, dann eine Metallschicht und darüber wiederum im Plasma-CVD-Verfahren aus einer SiCO- oder SiC-Atmosphäre eine Schutzschicht, die nachoxidiert wird. Sowohl die erste als auch zweite Schicht sollen vorwiegend Kohlenstoff enthalten. Dies wird erzielt, indem als Prozeßgas Hexamethyldisiloxan für die beiden Schichten verwendet wird. Bekanntermaßen soll dabei der vorwiegend vorhandene Kohlenstoff offensichtlich für eine bessere Haftung sorgen. Da in das zu beschichtende Kunststoff-Substrat keine elektrische Hochfrequenzenergie eingespeist wird, kann am Substrat auch grundsätzlich keine selbständige Substratspannung (Bias-Spannung) entstehen. Physikalisch gesehen, unterbleibt damit auch der zur Ausbildung harter Schichten erforderliche Beschuß mit energiereichen Ionen. Dadurch entstehen gemäß dieser Schrift sehr weiche Schichten mit stark organischem (=kohlenstoffhaltigem) Aufbau, die durch die oben erwähnte Nachoxidierung oberflächlich gefestigt werden müssen.

Die Aufgabe der Erfindung besteht darin, ausgehend von den Merkmalen im Oberbegriff des Patentanspuchs 1 ein verbessertes Verfahren zur Aufbringung einer Schicht anzugeben, die sich insbesondere auf blanken Metalloberflächen sowie auch Kunststoffen beliebiger Formgebung gleichmäßig abscheiden läßt, die die beschichtete Oberfläche zuverlässig gegen chemischen Angriff (Korrosion) schützt und gleichzeitig einen wirksamen Kratzschutz darstellt, ohne den metallisch blanken Farbeindruck einer polierten oder auch mattierten Oberfläche oder den farblos-durchsichtigen Polymerfarbstoff eines Kunststoffsubstrats zu beeinträchtigen, also transparent ist.

Diese Aufgabe wird durch die Merkmale des Patentanspruchs 1 gelöst. Vorteilhafte Weiterbildungen sind in den Unteransprüchen gekennzeichnet.

Gegenstand der Erfindung ist danach eine Verfahren, das zur Beschichtung einer blanken und korrosionsanfälligen Metalloberfläche z.B. von Messing, jedoch auch beliebigen anderen metallischen Oberflächen wie denen von verchromten Gegenständen und auch insbesondere weichen Polymeroberflächen dient. Das PACVD-(=Plasma Assisted Chemical Vapor Deposition)-Verfahren nutzt die Wirkung einer elektrischen Gasentladung bei vermindertem Druck in einer speziellen Atmosphäre (mit Sauerstoff und einer oder mehreren flüchtigen, gas- bzw. dampfförmigen siliziumorganischen Verbindungen), wobei eine sehr dünne, quarzähnliche Schicht allseitig gleichmäßig auf die zu schützenden Teile abgeschieden wird. Das zu beschichtende Substrat kann bei Raumtemperatur beschichtet werden. Bei dem erfindungsgemäßen Verfahren werden gleichzeitig mehrere sich ergänzende und gegenseitig unterstützende Maßnahmen ergriffen, um die gewünschten Eigenschaften der Schutzbeschichtung realisieren zu können.

Anders als bei rein chemischen Umsetzungen sind das Reaktionsgleichgewicht und der Ablauf der Einzelreaktionen der komplexen Umsetzung im Plasmavolumen und auf den zu beschichtenden Oberflächen durch die Wahl der physikalischen Plasmaparameter sehr feinfühlig einstellbar. Dies gilt vor allem, da im Plasma vorzugsweise Reaktionen von fragmentierendem Charakter ablaufen. Das Plasma wird zur Herstellung der erfindungsgemäßen Schicht so gesteuert, daß nicht, wie bisher angestrebt, extrem harte und damit auch spröde Schichten entstehen. So beobachteten die Erfinder, daß reine Quarzschichten, wie sie vor geraumer Zeit mit anderen Verfahren bereits bei sehr hoher Substrattemperatur von 1000 °C auf optischen Materialien abgeschieden wurden, auf duktilen Metalluntergründen wie z.B. Messing oder auch einem weichen Polymeruntergrund (z.B. PMMA, Polycarbonat, Polyester) den Charakter einer glasartigen Eierschale haben würden. Bei punktueller Belastung verformt sich der Grundwerkstoff zumindest an der Oberfläche, was den unweigerlichen Sprödbruch einer extrem harten Schicht zu Folge hätte.

Erfindungsgemäß wird die Abscheidung der Schicht im Plasma so gesteuert, daß eine eher zähharte Beschichtung in Form einer dünnen porenfreien inerten Schicht entsteht. Dies gelingt durch Zusammenspiel der folgenden erfindungsgemäßen Maßnahmen:
1. Der Anteil des reaktiven Sauerstoffs im Plasmagas wird so gewählt, daß die Menge zur quantitativen Umsetzung der siliziumorganischen Verbindung in Siliziumdioxid, Kohlendioxid und Wasser nicht ausreicht. Dies gilt entsprechend, wenn statt des Dampfes einer siliziumorganischen Verbindung z.B. Silangas verwendet wird.
   Auf diese Weise wird die Bildung von Quarzrauch, d.h. feinverteiltem Quarzstaub in der Gasphase verhindert, der entsteht, wenn die Reaktionsmechanismen bereits abgeschlossen sind, bevor die Schicht entsteht. Das Pulver würde die Ausbildung einer homogenen, geschlossenen Schicht unmöglich machen. Weiterhin entsteht keine Schicht aus schlecht mit der Unterlage verankerten, die Oberfläche aufrauhenden Quarz-Mikrokristalliten, sondern eine gut haftende amorphe Schichtstruktur. Die entstehenden Schichten sind farblos-klar, nicht trübe und nicht lichtstreuend. Das Erscheinungsbild der so beschichteten Gegenstände wird sichtbar nicht verändert. Für einen ausreichenden Schutz reichen dünne Schichten im Bereich von einigen um aus. Auch dickere Schichten bleiben farbneutral und klar. Darüber hinaus sind auch leichte, gezielt steuerbare Verdunkelungen der sichtbaren Farbe des Metalluntergrundes möglich.
2. Die fragmentierende Wirkung, verantwortlich für die Intensität der Reaktion und die Dichte des sich bildenden Reaktionsprodukts und realisiert über die kinetische Energie der im Feld beschleunigten Elektronen und Ionen, leicht beeinflußbar über die Abscheideparameter der elektrischen Gasentladung, nämlich die Parameter der Energieeinspeisung zur Plasmaerzeugung sowie die Substratspannung oder Self-Bias-Spannung, wird so gewählt, daß die schichtbildende siliziumorganische Verbindung nicht restlos in nieder- und niederstmolekulare Fragmente zerlegt wird. Mit anderen Worten wird die durch den Arbeitsdruck und die Höhe der eingespeisten elektrischen Energie beeinflußbare Substrat- oder Self-Bias-Spannung, welche die Härte, Elastizität und Verschleißfestigkeit der Schicht bestimmt, so gesteuert, daß die entstehende Schicht eine Mischstruktur aus Quarz mit eingelagerten organischen, plasma-polymerisierten Strukturkomponenten nach Art einer molekularmäßig homogenen Mischung in der amorphen quarzähnlichen Schicht aufweist. Die Werte der Substratspannung wurden anhand von Beschichtungsergebnissen eingegrenzt. Direkt meßbar an der Metalloberfläche oder einer kapazitiv angekoppelten Beschichtungselektrode bei Kunststoffoberflächen wird die Substratspannung unter Anpassung an die mechanischen Eigenschaften des zu beschichtenden Oberflächenmaterials auf Werte zwischen etwa 30 und etwa 300 V eingestellt. Darüber sind dann höhere Werte bis etwa 600 V und mehr für besonders harte und abriebbeständige Schichten möglich.

Die Reaktion im Plasma wird durch Wahl der äußeren Parameter (Arbeitsgaszusammensetzung und -druck sowie der über den Arbeitsgasdruck und die Plasmaleistung vorgebbaren Substratspannung) so gesteuert, daß in der wachsenden Quarzschicht Anteile oder Bereiche von elastischem, organischen Charakter bzw., bildhaft gesprochen, vom Charakter "Siliconkautschuk" entstehen. Die so entstehende Schicht aus elastisch verändertem Quarz ist gegen Verformung wesentlich widerstandsfähiger, weicht einer punktuellen Belastung aus und folgt der elastischen und zum Teil auch der plastischen Verformung des Untergrunds, ohne selbst Schaden zu nehmen. Insgesamt gesehen äußert sich dieses Verhalten in einer sehr hohen Schutzwirkung gegen reibenden und stoßenden Verschleiß (z.B. im Kratztest und im Sandrieseltest). Für die zusätzliche Korrosionsschutzwirkung der Schicht ist die amorphe, elastische Struktur ebenso von besonderem Vorteil.

Das Verfahren der Plasma-CVD-Reaktion bietet weiterhin die Möglichkeit, über die Beeinflussung der genannten äußeren Plasmaparameter während der laufenden Schichterzeugung die Eigenschaften der Schicht kontinuierlich oder sprungartig jederzeit ein- oder mehrfach zwischen der direkt auf dem Metall anhaftenden Grenzschicht bis zur Oberseite der fertigen Schutzbeschichtung zu verändern, wie bereits weiter oben ausgeführt.

Typischerweise wird direkt auf dem Substrat eine diesem in den mechanischen Eigenschaften (z.B. Elastizitätsmodul und bei Kunststoffen auch elastische Verformbarkeit) möglichst ähnliche und auch gut haftenden Schicht erzeugt. Während des weiteren Wachstums der Schicht werden deren Eigenschaften durch kontinuierliches Verändern der Abscheidebedingungen (Mischungsverhältnisse, Plasmaleistung, Gasdruck usw.) nach und nach verändert, um bei Erreichen der endgültigen Oberfläche die Schichteigenschaften zu erreichen, die für die gewünschte Kratzfestigkeit erforderlich sind. Von besonderem Vorteil ist dabei, daß die Haftung von Grundwerkstoff und Schichtmaterial aufeinander durch diese Art der Grenzflächen-Anpassung_{,} der Abstimmung der Elastzitätsmodule und der Verhinderung von inneren Schichtspannungen sehr positiv beeinflußt wird.

Der beschriebene Gradient der Schichteigenschaften kann kontinuierlich und monoton über die gesamte Beschichtungsdicke eingestellt werden oder kann sich nur auf den Bereich der unmittelbaren Grenzfläche beschränken. An Stelle kontinuierlicher, fließender Übergänge können auch Übergänge durch eine Vielzahl sehr dünner Schichten mit periodisch sprungartig wechselnden Eigenschaften erzeugt werden, um die gewünschten Eigenschaften der Oberfläche zu erzeugen.

Analog wie die beschriebenen mechanischen Eigenschaften lassen sich auch die optischen Eigenschaften der abzuscheidenden Schichten durch die Wahl der Abscheidebedingungen gezielt steuern. Dies kann im erfindungsgemäßen Verfahren dazu benutzt werden, vor allem die optische Brechzahl der farblos-klaren Schichten gezielt einzustellen. Auf diese Weise können die Reflexionseigenschaften der Schicht so beeinflußt werden, daß die ansonsten farblosen Schichten sehr deutliche Interferenzeffekte zeigen (buntes Schillern) oder daß im Gegenteil das Auftreten von Interferenzfarben durch eine als Antireflexschicht wirkende oberste Schichtlage (Entspiegelungsschicht) verhindert wird. Im ersten Fall kann die dekorative Wirkung bunter, schillernder Effekte genutzt werden; im zweiten Fall tritt bei Metallkörpern der reine Metallglanz der beschichteten Unterlage besonders klar in Erscheinung. Die mattierende oder polierende Wirkung einer entsprechenden Oberflächenbearbeitung des metallischen Grundwerkstoffs wird durch die erfindungsgemäße Beschichtung nicht verändert.

Bei unedlen, in einer Sauerstoffatmosphäre anlaufenden Metallen ist ferner folgendes Merkmal für das erfindungsgemäße Schichterzeugungsverfahren im Gegensatz zu beispielsweise Chromoberflächen aus den im folgenden dargelegten Gründen wesentlich für eine erfolgreiche Beschichtung.

Nach der üblichen und allgemein mechanischen und chemischen Reinigung und Entfettung der zu schützenden Oberflächen werden diese von den letzten anhaftenden Verunreinigungen im Plasma gereinigt. Diese bekannte Maßnahme findet erfindungsgemäß unmittelbar vor der Beschichtung in der selben Unterdruckkammer ohne Unterbrechung des Vakuums statt. Die besonderen Eigenschaften von Grundwerkstoffen wie z.B. Messing oder Silber gestatten allerdings nicht die bekannte Reinigungsprozedur, bei der in einer Sauerstoff- oder zumindest sauerstoffhaltigen Atmosphäre letzte organische Verschmutzungen durch die Einwirkung von aktiviertem Sauerstoff zu Kohlendioxid und Wasser kalt verbrannt werden. Eine derartige Reinigungsprozedur führt allgemein zu einer sehr schlechten, zumindest ungenügenden Haftung der unmittelbar danach aufzubringenden Schutzschicht, da gleichzeitig beim Entfernen organischer Verunreinigungen das Kupfer und Zink des Messings im Plasma oxidiert wird und eine sehr dünne und schlecht haftende Oxidschicht ausbildet, welche eine anschließende gute Haftung der aufzubringenden Schutzschicht verhindern, was sich insbesondere beim späteren Gebrauch unter feuchten Umgebungsbedingungen bemerkbar macht.

Bei dem Versuch, diese Problematik zu lösen, ermittelten die Erfinder, daß die Metalloberfläche im Plasma gleichzeitig durch kalte Verbrennung von organischen Schmutzresten befreit (oxidative Wirkung) und selbst durch Zugabe eines reduzierend wirkenden Mediums vor einer Oxidation bewahrt werden kann (reduktive Wirkung des Plasmas). Dies gelingt auf überraschend einfache Weise durch gleichzeitige Beimischung des oxidierenden Sauerstoffs und des reduzierenden Stoffs, vorzugsweise Wasserstoff, zum Plasma-Inertgas, vorzugsweise Argon. Bei einem Mischungsverhältniss von 1 bis 6 Vol.-Teilen Wasserstoff und 1 bis 6 Vol.-Teilen Sauerstoff zu 0 bis 3 Vol.-Teilen Argon, typischerweise im Verhältnis 3:2:0 bei 0,02 mbar Arbeitsdruck wurden gute Reinigungsergebnisse erzielt. Wegen des sehr niedrigen Arbeitsdrucks von beispielsweise 0,01 bis 0,05 mbar findet keine Knallgasreaktion statt.

Zu beschichtende Körper, insbesondere plattenförmige Kunststoffteile können ohne weitere chemische Vorreinigung verwendet werden, wenn die vom Hersteller üblicherweise aufgebrachte Schutzfolie erst unmittelbar vor der Beschichtung abgezogen wird. Ansonsten genügt meist ein Abwischen mit Alkohol. Das zu verwendende Wischmaterial sollte dem empfindlichen Beschichtungsgut entsprechend weich sein, um ein vorzeitiges Zerkratzen der noch unbeschichteten Oberfläche zu vermeiden.

Nach einer mechanischen und gegebenenfalls chemischen Reinigung und Entfettung der zu schützenden Oberflächen werden diese vorzugsweise von den letzten anhaftenden Verunreinigungen im Plasma gereinigt. Diese an sich bekannte Maßnahme findet unmittelbar vor der Beschichtung in der selben Unterdruckkammer ohne Unterbrechung des Vakuums statt.

Bei einer Plasmareinigung bekannter Art in einer Gasmischung, die neben Argon auch Sauerstoff und/oder andere reaktive Komponenten enthalten kann, wird normalerweise die gewünschte Haftqualität auch der erfindungsgemäßen Schichten problemlos erreicht. Erst nach längerer Zeit, insbesondere Einwirkung von Luftfeuchte und Licht, zeigte sich, daß die so gereinigte Grenzfläche im Falle von Kunststoffoberflächen je nach Material und Beanspruchung nicht stabil ist und es im Laufe der Zeit zu Ablösungserscheinungen kommen kann.

Überraschernderweise können mit der gleichen Technik qualitativ gleichwertige, dabei jedoch dauerhaft beständige Schichten erzeugt werden, wenn bei der in den Prozeß integrierten Vorreinigung statt des Argon als Plasmagas teilweise oder ausschließlich Helium benutzt wird. Ursache dieses unerwarteten Effekts kann sein, daß die schweren, im Plasma auf hohe Energien beschleunigten Argonionen in der Polymermatrix eines Kunststoffs durch Stoßübertrag Brüche in den Molekülketten erzeugen. Die durch die Brüche entstehenden freien Radikale könnten durch Schädigung des Basispolymers als Ausgangszentren von Haftungsausfällen wirken. Wahrscheinlich werden, wie sich aus den beständigeren Schichten bei Heliumreinigung ableiten läßt, diese nachteiligen Effekte durch die geringere Masse des Heliums vermieden. Zusätzlich kann die im Plasma erzeugte kurzwellige UV-Strahlung ebenfalls Strahlungsschäden an der Grenzfläche erzeugen. Auch die Emissionsspektren von Helium und Argon unterscheiden sich deutlich. Dennoch hat man bisher standardmäßig Argon für die Reinigung verwendet.

Die besonderen Eigenschaften von polymeren Grundwerkstoffen gestatten es, die Beseitigung von Verunreinigungen gleichzeitig mit einer molekularen Aktivierung der Oberfläche des Werkstoffs zu koppeln, wobei durch die unmittelbar im Anschluß daran erfolgende Beschichtung ohne Unterbrechung des Vakuums eine Verankerung der aufwachsenden Schicht im Grundwerkstoff auf molekularer Ebene ermöglicht wird.

Unmittelbar im Anschluß an die reinigende Entladung im Plasma werden mit Hilfe der PACVD-Technik mit Hilfe einer elektrischen Gasentladung bei vermindertem Druck, vorzugsweise mit den in den Unteransprüchen angegebenen Frequenzen und Drücken erzeugt. Als Quellmaterial für die beschriebenen, in den mechanischen Eigenschaften modifizierten siliziumorganischen Beschichtungen zur kratzfesten und korrosionsbeständigen Beschichtung blanker Metalloberflächen, wie insbesondere Messing und durchsichtigen farblosklaren Polycarbonaten, PMMA, Polyester und anderen Polymeren, dienen leicht und preiswert verfügbare siliziumorganische Verbindungen wie z.B. Hexamethyldisilan (HMDS) oder Hexamethyldisiloxan (HMDSO). Diese leicht flüchtigen Flüssigkeiten wurden dosiert in Dampfform in die PACVD-Vorrichtung eingespeist. Weitere, dosiert eingespeiste Zusatzgase wie inertes Argon und reaktiver Sauerstoff dienten als Trägergas, zur Erzeugung der elektrischen Beeinflussung der elektrischen Entladung und zur Steuerung der Reaktion zur Ausbildung der modifizierten zähharten, quarzähnlichen Schicht. Das Gasgemisch erfüllte die Beschichtungsanlage gleichmäßig, was zu einem gleichmäßigen Wachstum der gewünschten Schicht auch auf kompliziert geformten Teilen führte.

Die organischen Komponenten der Verbindung werden beim Beschichten mehr oder weniger in ihre gasförmigen Oxide umgewandelt und mit dem Abgas aus dem Reaktionsvolumen entfernt, oder im Sinne einer Poly-merisation niedergeschlagen und als elastisch modifizierte Komponente in die wachsende Schicht eingebaut.

Im einzelnen wurde z.B. zur Beschichtung von Messingteilen folgendermaßen vorgegangen: (Auf die abweichenden Bedingungen für die Beschichtung von Kunststoffteilen wurde und wird jeweils in der Beschreibung hingewiesen.)

### 1. Vorreinigung

Die polierten Teile wurden von den Rückständen des Poliermittels befreit und anschließend etwa zehn Minuten im Ultraschallbad mit Aceton gereinigt. Abschließend erfolgte eine Reinigung im Alkoholdampfbad.

### 2. Zusätzliche Plasma-Vorreinigung

Die Plasmareinigung fand in einer Unterdruckkammer statt, die mittels mechanischer Pumpen auf einen Anfangsdruck von 0,01 mbar oder weniger gebracht wurde. In den Kammerraum wurde ein Reinigungsgemisch von Wasserstoff zu Sauerstoff im Volumenverhältnis 2:3 eingeleitet, wobei sich zwischen der eingeleiteten Menge und dem Saugvermögen der Pumpe ein Gleichgewicht bei etwa 0,02 mbar einstellte. Zur Plasmaerzeugung wurde der Raum mit Hochfrequenzenergie versorgt (Frequenz 13,56 MHz), wobei die vor der Beschichtung zu reinigenden metallischen Teile über ein Anpassungsnetzwerk mit dem Ausgang des Hochfrequenzgenerators verbunden wurden. In der verwendeten 100-Liter Druckkammer baute sich bei einer Hochfrequenzleistung von 100 Watt eine Self-Biasspannung von etwa 500 V auf. Die Reinigungszeit betrug 5 min.

### 3. PACVD-Beschichtung

Nach Abschluß der Reinigung wurde die Wasserstoff-Sauerstoffeinleitung ohne Belüftung der Druckkammer durch die Einspeisung des Reaktionsgemischs aus HMDSO und Sauerstoff im Volumenverhältnis 1:15 ersetzt. Es stellte sich ein dynamisches Druckgleichgewicht von 0,05 mbar ein. Bei einer Hochfrequenzleistung von 200 Watt baute sich eine Self-Biasspannung von etwa 350 V auf. Für eine Beschichtungsdicke von 5 µm war eine Beschichtungszeit von einer Stunde erforderlich.

Die erzielte Beschichtung war vollkommen farblos, kratzfest und absolut korrosionsschützend. Auch mattierte Oberflächen wurden auf diese Weise erfolgreich beschichtet.

Auf anderen Metalloberflächen wie Chromoberflächen und Silber ist das erfindungsgemäße Verfahren ebenfalls einsetzbar, wobei bei Chrom aus den oben genannten Gründen die Plasmareinigung auch ohne den Wasserstoffzusatz erfolgen kann.

Auch kann in an sich bekannter Weise sowohl bei der Plasmareinigung als auch der eigentlichen Beschichtung ein Inertgas, z.B. Argon als Trägergas eingesetzt werden. Ferner ist prinzipiell der Einsatz von Kohlenmonoxid als reduzierende Komponente für die Plasmareinigung möglich.

Bei den Kunststoffsubstraten unterschied sich Schritt 3 von der obigen Vorgehensweise bei metallischen Oberflächen bzw. Körpern. Eine Vorreinigung kann hier, wie bereits oben dargelegt, gegebenenfalls auf ein Abwischen mit Alkohol beschränkt werden.

Bei plattenförmigen Kunststoffteilen mit Schutzfolie reichte diese Maßnahme regelmäßig aus.

Die Plasmareinigung fand in einer Unterdruckkammer statt, die mittels mechanischer Pumpen auf einen Anfangsdruck von 0,01 mbar oder weniger gebracht wurde. In den Kammerraum wurde in einer Reihe von Verfahrensbeispielen das Reinigungsgas Argon eingeleitet. Dann wurde jedoch stattdessen nach einer bevorzugten Weiterbildung des Verfahrens mit Helium statt Argon gearbeitet, wobei sich in beiden Fällen zwischen der eingeleiteten Menge und dem Saugvermögen der Pumpe ein Gleichgewicht bei etwa 0,04 mbar einstellte. Zur Plasmaerzeugung wurde der Raum mit Hochfrequenzenergie versorgt (Frequenz 13,56 MHz), wobei die vor der Beschichtung zu reinigenden Kunststoffteile auf einer metallischen Elektrode lagen oder verbunden waren, die mit dem Ausgang des Hochfrequenzgenerators über ein Anpassungsnetzwerk verbunden war. Die zur Reinigung verwendete Hochfrequenzleistung betrug etwa 100 Watt. Die Reinigungszeit betrug für Argon und Helium einige Minuten.

Nach Abschluß der Reinigung wurde die Wasserstoff-Sauerstoffeinleitung ohne Belüftung der Druckkammer durch die Einspeisung des Reaktionsgemischs aus HMDSO und Sauerstoff im Volumenverhältnis 1:15 ersetzt. Es stellte sich ein dynamisches Druckgleichgewicht von 0,05 mbar ein. Bei einer Hochfrequenzleistung von 200 Watt baute sich eine Self-Biasspannung von etwa 350 V auf. Für eine Beschichtungsdicke von 5 µm war eine Beschichtungszeit von einer Stunde erforderlich.

Die erzielten Beschichtungen waren vollkommen farblos, kratzfest und absolut korrosionsschützend. Die beschichteten Gegenstände wurden während der Beschichtung praktisch nicht oder kaum über Raumtemperatur erwärmt.

## Patentansprüche

1. Verfahren zur Beschichtung von Gegenständen aus Metall, Metall-Legierungen, Kunststoffen oder mit entsprechenden Oberflächen mit einer Schutzschicht nach vorheriger Reinigung mittels eines plasmaunterstützten CVD-Verfahrens (PACVD-Verfahrens) durch eine elektrische Plasmaanregung bei vermindertem Gasdruck unter Einleitung einer Gasmischung mit reaktionsfähigen, schichtbildenden Gasen und Steuerung des Arbeitsdrucks, wobei zur Bildung einer quarzartigen Schicht als die reaktionsfähigen Gase neben Sauerstoff der Dampf einer das Element Silizium in organischer Verbindung enthaltenden, leicht verdampfbaren siliziumorganischen Verbindung oder ein siliziumhaltiges Gas eingeleitet werden,
dadurch gekennzeichnet,
daß die reaktionsfähigen Gase in einer solchen Mischung eingeleitet werden, daß der Anteil des reaktiven Sauerstoffs nicht zur quantitativen Umsetzung zu Siliziumdioxid ausreicht, und daß die Abscheideparameter der elektrischen Gasentladung so gesteuert werden, daß sich eine quarzähnliche Schicht bildet, die neben Silizium und Sauerstoff auch organische, plasma-polymerisierte Komonenten in homogener Verteilung enthält.

2. Verfahren nach Anspruch 1,
dadurch gekennzeichnet,
daß die reaktionsfähigen Gase als eine Mischung aus der siliziumorganischen Verbindung, vorzugsweise in Form von Hexamethyldisiloxan (HMDSO) oder Tetraethoxysilan (TEOS), und Sauerstoff mit einem molaren Mischungsverhältnis im Bereich von 1:1 bis 1:50 eingesetzt werden und der Arbeitsdruck zwischen 0,02 mbar und 0,2 mbar eingestellt wird und speziell bei HMDSO vorzugsweise im Verhältnis 1:15 gemischt wird und bei 0,05 mbar gearbeitet wird.

3. Verfahren nach Anspruch 1 oder 2,
dadurch gekennzeichnet,
daß der Mischung aus der siliziumorganischen Verbindung und Sauerstoff ein inertes Trägergas, vorzugsweise Argon, im molaren Verhältnis 1:1:0 bis 1:50:50 zugemischt wird.

4. Verfahren nach einem der vorhergehenden Ansprüche,
dadurch gekennzeichnet,
daß die Substratspannung auf Werte zwischen etwa 30 und 600 Volt eingestellt wird.

5. Verfahren nach einem der vorhergehenden Ansprüche,
dadurch gekennzeichnet,
daß die zu beschichtenden Gegenstände außerhalb des Plasmabereichs ohne elektrische Verbindung mit dem Generator so positioniert werden, daß sich die Reaktionsprodukte des Plasmas ohne Plasmaeinwirkung wie Ionenbeschuß auf den Gegenständen niederschlagen und die Schicht bilden können.

6. Verfahren nach einem der vorhergehenden Ansprüche,
dadurch gekennzeichnet,
daß zur elektrischen Energieeinspeisung zur Erzeugung des Plasmas Einzelanregungen oder deren Kombinationen verwendet werden, wie Gleichspannung, mono- und bipolare Gleichspannungs-Pulstechnik, Mittelfrequenz (typischerweise 30-60 kHz), Hochfrequenz im Megahertzbereich (typischerweise 13,56 MHz) oder Mikrowellenanregung bei typischerweise 2,45 GHz.

7. Verfahren nach einem der vorhergehenden Ansprüche,
dadurch gekennzeichnet,
daß die Energieeinspeisung zur Erzeugung des Plasmas so gewählt wird, daß die verwendeten Gase und Dämpfe ionisiert werden und sich durch ein elektrisches Feld auf den Substratoberflächen abscheiden, wobei bei Hochfrequenz-Anregung die Gasentladungs-Anregungsfrequenz im Bereich von 1 bis 50 MHz, insbesondere auf 13,56 MHz eingestellt wird.

8. Verfahren nach einem der vorhergehenden Ansprüche,
dadurch gekennzeichnet,
daß die Schichteigenschaften während des Schichtwachstums über die Steuerung der Plasmaparameter: Gaszusammensetzung, Gasdruck und Substratspannung kontinuierlich so verändert werden, daß die wachsende Schicht auf der Gegenstandsoberfläche unter Berücksichtigung deren mechanischer Eigenschaften relativ weich und elastisch beginnt und mit zunehmender Dicke auf der Oberfläche immer größerer Härte erreicht.

9. Verfahren nach einem der Ansprüche 1 bis 7,
dadurch gekennzeichnet,
daß die Schichteigenschaften während des Schichtwachstums über die Umschaltung der Plasmaparameter: Gaszusammensetzung, Gasdruck und Substratspannung kontinuierlich so gewechselt werden, daß die wachsende Schicht unter Berücksichtigung der mechanischen Eigenschaften der Gegenstandsoberfläche in Form einer viellagigen Struktur im Wechsel zwischen weich-elastisch und hart aufgebaut wird, um innere und äußere Schichtspannungen aufzufangen, die Schichthaftung zu gewährleisten und der Schicht besonders hohe Verscheißfestigkeit zu verleihen.

10. Verfahren nach einem der vorhergehenden Ansprüche,
dadurch gekennzeichnet,
daß die Höhe des Substratspannung zwischen etwa 30 Volt und etwa 300 Volt für vorzugsweise zäh-elastische Schichtbereiche und zwischen etwa 300 Volt und etwa 600 Volt für vorzugsweise harte und abriebbeständige Schichtbereiche eingestellt, wobei eine kontinuierliche oder wechselweise Steuerung zwischen und innerhalb dieser Bereiche wählbar sind.

11. Verfahren nach einem der vorhergehenden Ansprüche,
dadurch gekennzeichnet,
daß im Fall der Beschichtung auf blanken sowie unedlen, in einer Sauerstoffatmosphäre anlaufenden Metalloberflächen, insbesondere aus Messing oder Silber, eine der eigentlichen Beschichtung vorgeschaltete, plasmachemische Vorreinigung unter Ausnutzung von Sauerstoff oder sauerstoffhaltigem Gas und Inertgas zur Entfernung von anhaftenden organischen Schmutzresten durch Oxidation so durchgeführt wird, daß die zu reinigende Oberfläche neben der oxidierenden Komponente Sauerstoff zusätzlich einer reduzierend wirkenden Komponente im Reinigungsgas ausgesetzt wird, die das zu reinigende Metall vor einer Oxidation schützt.

12. Verfahren nach Anspruch 10,
dadurch gekennzeichnet,
daß als die reduzierende Komponente Wasserstoff zugeführt wird, wobei das Mischungsverhältnis der Komponenten im eingeleiteten Reinigungsgas Wasserstoff:Sauerstoff:Argon im Verhältnis von 1:6:3 bis 6:1:0 eingestellt wird.

13. Verfahren nach einem der Ansprüche 1 bis 9,
dadurch gekennzeichnet,
daß die zu beschichtenden Oberflächen, insbesondere aus Kunststoff, in derselben Beschichtungskammer einer plasmachemischen Vorreinigung mit einem Inertgas, vorzugsweise Helium, unterzogen werden.

14. Verfahren nach einem der Ansprüche 10 bis 13,
dadurch gekennzeichnet,
daß ohne Belüftung des Reaktionsvolumens unterbrechungsfrei nach der Plasma-Reinigung auf die plasmaunterstützt Beschichtung umgeschaltet wird.
